# EUROPEAN PATENT SPECIFICATION

(11) **EP 3 624 170 B1**
(45) Date of publication and mention of the grant of the patent: **03.03.2021**
(21) Application number: 18194201.2
(22) Date of filing: 13.09.2018
(51) Int. Cl.: H01L 21/304

(54) **TRANSFER OF TWO-DIMENSIONAL LAYERS**
TRANSFER VON ZWEIDIMENSIONALEN SCHICHTEN
TRANSFERT DE COUCHES BIDIMENSIONNELLES

(43) Date of publication of application: 18.03.2020
(73) Proprietor: IMEC vzw, 3001 Leuven (BE); Katholieke Universiteit Leuven KU Leuven Research & Development, 3000 Leuven (BE)
(72) Inventor: BREMS, Steven, 3001 Leuven (BE); HUYGHEBAERT, Cedric, 3001 Leuven (BE); VERGUTS, Ken, 3001 Leuven (BE)
(74) Representative: DenK iP bv

(56) References cited:
- EP-A1- 3 333 126
- WO-A1-2017/037260
- JP-A- 2004 022 602

## Description

### Field of the invention

The present invention relates to the field of methods for transferring 2D-layers. More specifically it relates to methods which facilitate mechanical delamination of the 2D-layer from the growth substrate.

### Background of the invention

Two dimensional (2D) materials are the ultimate scaled materials in the third dimension. The extraordinary physical properties of 2D materials have the potential to both enhance existing technologies and also create a range of new applications. 2D materials (e.g. graphene, h-BN, MoS2, WS2, MoSe2) are typically grown at high temperatures (>> 500°C), which makes direct integration of these materials in CMOS lines almost impossible. Therefore, these 2D materials have to be transferred from the growth wafer to a target wafer.

Such a transfer typically consists of two steps. First, the 2D layer needs to be lifted from the growth substrate using a carrier, and next, the 2D layer needs to be bonded to a target wafer after which the carrier needs to be removed. Care should be taken when developing such a method because Van der Waals bonded materials, which are influenced by its surroundings (ambient and substrate), are sensitive to delamination.

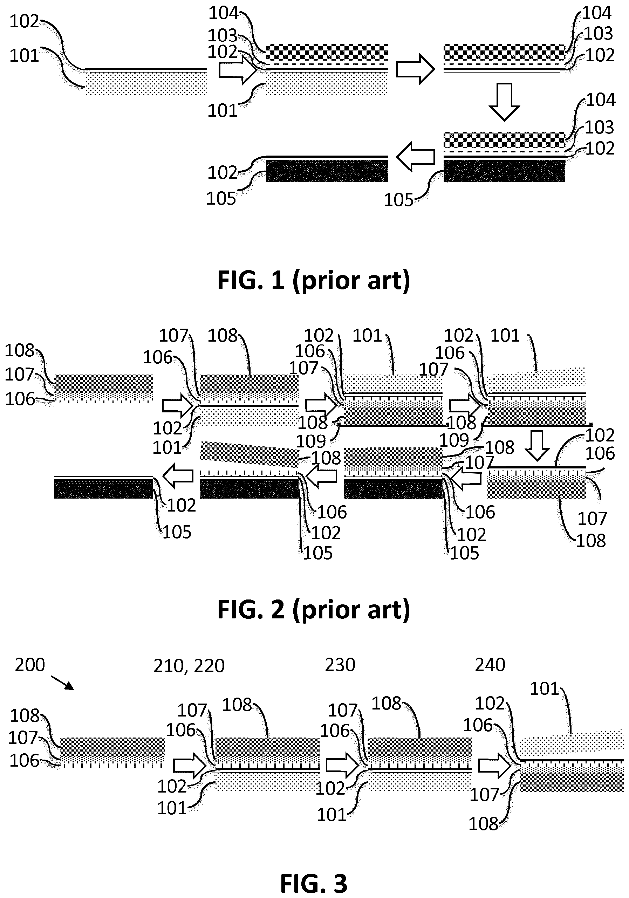

Prior art 2D transfer routes are illustrated in FIG. 1 and FIG. 2. FIG. 1 shows a prior art baseline water assisted transfer method. A stack of a film 102 and a growth wafer 101 is provided. In this example the film is a metal dichalcogenide (MX₂). A stack of a polymethyl methacrylate (PMMA) layer 103 and thermal release tape 104 is provided on the film 102. Using water and ultrasound assisted MX₂ peeling the growth wafer 101 is removed from the obtained stack. The remaining stack is mounted by dry bonding on the target substrate 105 such that the film 102 is in contact with the target substrate. Next the thermal release tape 104 is peeled and the PMMA is dissolved.

In FIG. 2, a glass carrier wafer 108 with a laser release layer 107 and adhesive layer 106 is prepared by spin coating. Thus, a temporary stack is obtained. This temporary stack is temporary bonded on a 2D material 102 which is grown on a growth substrate 101. After bonding, the glass carrier wafer 108 is mounted on a dicing tape 109 and the growth wafer 101 (e.g. Si/SiO₂ growth wafer) on which the 2D material 102 is present is mechanically debonded from the 2D material. Next UV curing is applied and the dicing tape 109 is detached. After which, the glass carrier 108 with the 2D material 102 is bonded to a target wafer 105. This may for example be achieved by permanent bonding at a pressure below 1e-5 mbar. Finally, the glass carrier 108 is removed using a laser release step. This allows to remove the glass carrier with zero force. The adhesive 106 is dissolved and the solvent is cleaned. This is one of the possibilities of a 2D transfer process. Several variations on this transfer process using different carriers (e.g. thermal release tapes, only a polymer layer...) and different 2D material debonding techniques from the growth wafer (e.g. etching, water assisted peeling methods) can be find in literature.

If the adhesion between the 2D material and the growth wafer is too high, the mechanical delamination (i.e. dry debonding) gets more difficult or even impossible.

There is therefore a need for solutions to decrease the adhesion between the 2D layer and the growth substrate. In the prior art several directions are being explored. One could change the 2D material/growth wafer interface during the growth of the materials in order to achieve a lower adhesion value. If this is not possible, one could try to intercalate molecules between the 2D layer and the growth wafer. This has been demonstrated with graphene grown on Pt (and also on Cu). The graphene/Pt stack is submerged in warm water for several hours (up to several days) and as a consequence, water intercalates at the graphene/Pt interface. This intercalation weakens the interface, which makes graphene delamination easier. The main problem is that this intercalation takes a long time.

Graphene delamination may alternatively be done by etching of the growth catalyst wafer (e.g. etching the Cu layer). However, this etching is too time consuming and will lead to a contaminated graphene sheet.

A metal dichalcogenide (MX₂) may be delaminated from sapphire by using warm water (often in combination with some physical force (e.g. ultrasound)). The main disadvantage is that these MX2 materials are prone to oxidation and it would be preferable to avoid any water exposure during the transfer of MX2 materials JP2004022602 A and EP3333126 A1 relate to methods of delaminating a film from a substrate.

There is therefore a need for good methods to delaminate a film from a substrate.

### Summary of the invention

It is an object of embodiments of the present invention to provide a good method for delaminating a film from a substrate.

The above objective is accomplished by a method according to appended claim 1, with dependent claims defining additional features.

The substrate of a first material in direct contact with on top thereof a film of a second material may be obtained by a specific growth method. If the van der Waals force for the specific growth substrate/film is too high, it might be difficult or even impossible to peel the 2D material without an intercalation step.

It is an advantage of embodiments of the present invention that by intercalating the supercritical fluid between the thin film and the substrate a reduced adhesion between the film and the substrate can be obtained. Hence mechanical peeling of the substrate from the film is enhanced by intercalating the supercritical fluid.

The first material and the second material may be epitaxially matched. In case of epitaxial matching between the first and the second material, oriented islands of the second material can be achieved with a reduced number of grain boundaries compared to substrates and films for which the materials are not epitaxially matched. This epitaxial matching, however, may lead to an even higher bonding strength between the substrate and the film. It is an advantage of embodiments of the present invention that this bonding strength can be reduced by intercalating the supercritical fluid between the thin film and the substrate.

In embodiments of the present invention the first material of the provided substrate is sapphire.

It is an advantage of embodiments of the present invention that oriented growth of for example a metal dichalcogenide is possible on sapphire.

In embodiments of the present invention the first material of the provided substrate is aluminum nitride.

It is an advantage of embodiments of the present invention that high quality films can be grown on Sapphire or Aluminum Nitride substrates.

In embodiments of the present invention the second material is a metal dichalcogenide.

In embodiments of the present invention the first material is platinum or copper, and the second material is graphene.

In embodiments of the present invention the second material is hexagonal boron nitride.

In embodiments of the present invention the supercritical fluid comprises non-polar molecules.

In embodiments of the present invention the supercritical fluid comprises CO2.

In embodiments of the present invention the supercritical fluid comprises polar molecules.

It is an advantage of embodiments of the present invention that small (comparable to CO₂) polar molecules intercalate faster between for example graphene and the growth wafer than supercritical CO₂ does.

Methods according to embodiments of the present invention may furthermore comprise transferring the film to a target after peeling the substrate from the film and removing the carrier.

It is an advantage of embodiments of the present invention that the target and the film can be separately processed. This allows for example to process the film at higher temperatures than the temperatures which are allowed for the target.

In embodiments of the present invention the target is made using a CMOS process flow.

It is an advantage of embodiments of the present invention that films such as metal dichalcogenide films, graphene films, or h-BN films can be transferred on a CMOS stack without damaging the CMOS stack.

In embodiments of the present invention the film is transferred on the target after a processing step of the target in the front end of line.

In embodiments of the present invention the film is transferred on the target after a processing step of the target in the back end of line.

In embodiments of the present invention a passivation layer is applied on the target before transferring the film.

It is an advantage of embodiments of the present invention that uncontrolled oxidation can be avoided by providing a passivation layer before transferring the film.

In embodiments of the present invention a laser release layer is provided between the adhesive and the carrier.

Particular and preferred aspects of the invention are set out in the accompanying independent and dependent claims.

### Brief description of the drawings

FIG. 1 shows schematic drawings of intermediate stacks obtained in a prior art baseline water assisted transfer method.
FIG. 2 shows a prior art transfer method of a film wherein the stacks are comprising a laser release layer for removal of the glass carrier with zero force.
FIG. 3 shows different stacks obtained when executing method steps in accordance with embodiments of the present invention.
FIG. 4 shows an image of a glass carrier after peeling the growth substrate from the film using a method in accordance with embodiments of the present invention.
FIG. 5 shows an image of a growth wafer after peeling it of from the film using a method in accordance with embodiments of the present invention.
FIG. 6 shows the intensity in function of the Raman shift on the stack of FIG. 4.

Any reference signs in the claims shall not be construed as limiting the scope. In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Where in embodiments of the present invention reference is made to a film reference is made to a 2-dimensional surface which may for example comprise less than 20 layers, or even less than 10 layers, for example 1, 2, 3, 4 or 5 layers.

The present invention relates to a method 200 for delaminating such a film 102 from a substrate 101. This substrate may for example be a growth wafer.

The method comprises providing 210 a substrate 101 of a first material in direct contact with on top thereof a film 102 of a second material. The substrate of a first material with on top thereof a film of a second material may be obtained by a specific growth method. The first material and the second material may be epitaxially matched.

The method moreover comprises bonding 220 the film 102 to a carrier 108 using an adhesive 106. This adhesive has a glass transition temperature.

Before mechanically peeling 240 the substrate 101 from the film 102 a supercritical fluid is intercalated 230 between the film 102 and the substrate 101. The supercritical fluid should have a critical temperature below the glass transition temperature of the adhesive 106. By intercalating the supercritical fluid between the thin film and the substrate a reduced adhesion between the film and the substrate can be obtained. This reduction of the adhesion by the intercalation with the supercritical fluid enables dry debonding of the film from the substrate.

In embodiments of the present invention the supercritical fluid may for example comprise non-polar molecules such as CO2.

In embodiments of the present invention the supercritical fluid may comprise polar molecules such as H₂O, CHF₃, CH₃F, CH₃OH, CO, N₂O. Even a combination of supercritical CO₂ with a polar molecule may be used. The choice of the supercritical fluid depends on the materials of which the growth substrate 101 and the film 102 are made.

FIG. 3 shows different stacks obtained when executing method steps in accordance with embodiments of the present invention.

The illustrated method comprises providing 210 a substrate 101 in direct contact with on top thereof a film 102 of a second material. The substrate 101 may for example be made of sapphire or aluminum nitride. The second material may for example be a metal dichalcogenide (MX₂). Sapphire is a promising substrate material for MX2 growth, since oriented MX2 growth is possible on sapphire.

In this example the method moreover comprises bonding 220 the film 102 to a carrier 108 (this may for example be a glass carrier) using an adhesive 106. The adhesive is used as a temporary bonding material. In this example a laser release layer 107 is present between the adhesive 106 and the carrier 108.

In a next step 230 a supercritical fluid is intercalated 230 between the film 102 and the substrate 101 to reduce the adhesion force. This reduction of the adhesion force between both enables mechanical peeling of the film from the substrate. Because of the supercritical character the exposure time can be reduced. The exposure time may for example be shorter than 15 minutes or even shorter than 2 minutes. This time may be dependent on the material properties. For example in case of MX₂, the necessary time to have a fully intercalated sample may be mainly dependent on the MX₂ grain size.

This reduction of the adhesion force between both enables mechanical peeling of the film from the substrate. This is done in a next step wherein the substrate 101 is mechanically peeled 240 from the film 102.

In embodiments of the present invention the second material of the film 102 may for example be a Dichalcogenide (MX₂) such as Molybdenum Disulfide (MoS₂), Tungsten Disulfide (WS₂), Molybdenum Diselenide (MoSe₂). In that case CO₂ may for example be intercalated between sapphire 101 and MX₂ material 102 in order to reduce the adhesion between both.

In embodiments of the present invention the first material may be Platinum or Copper and the second material may be graphene. In case of for example graphene films (e.g. graphene grown on a Pt surface), small molecules (comparable in size to CO₂) may be used for intercalation between the growth wafer and the film. For example, polar molecules may be used. It is an advantage of embodiments of the present invention that a small polar molecule in a supercritical state intercalates faster between graphene and the growth wafer than a larger molecule such as CO₂.

In embodiments of the present invention the film may be a hexagonal boron nitride film (hBN). Several templates are reported in literature for growing hBN. See for example: "Chang et.al. Chem. Mater., 2017, 29 (15), pp 6252-6260". Therein a growth method is described for a range of different catalyst metals and insulating substrates such as SiO₂ and sapphire.

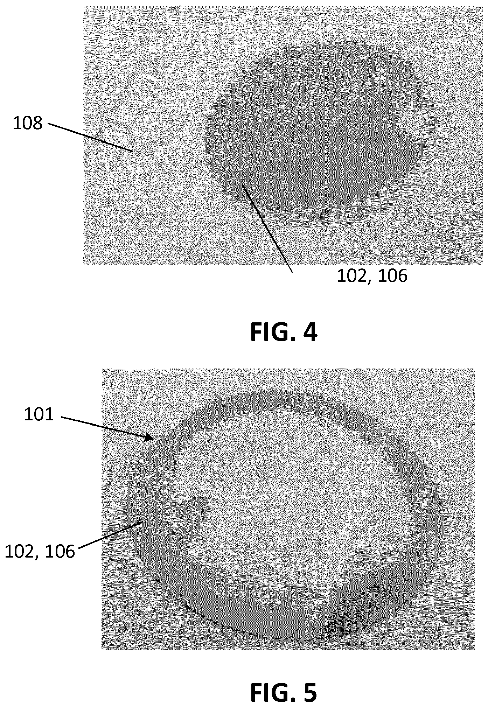

FIG. 4 and FIG. 5 are photographs of respectively the glass carrier 108 and the growth substrate 101 after peeling the growth substrate in accordance with embodiments of the present invention.

In FIG. 4 the glass carrier 108 can be seen with on top thereof the film 102 which is bonded to the glass carrier using an adhesive 106. The film 102 in this example was made of MoS₂ and the growth substrate 101 was a sapphire substrate. MoS₂ is epitaxially matched to sapphire.

FIG. 5 shows that the adhesive 106 and the film 102 are successfully removed from the growth wafer 101 after supercritical CO₂ drying and after mechanical peeling of the growth substrate. Only at the edges the adhesive 106 with the MoS₂ film 102 is remaining. In the center no traces of the adhesive 106 with the MoS2 film remain present.

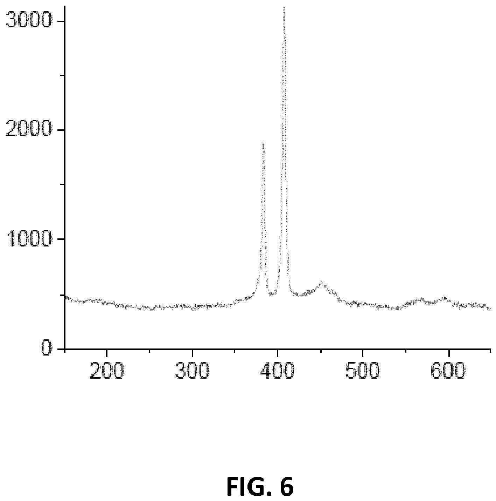

FIG. 4 to 6 show that the peeling of the MoS₂ layer is possible after the supercritical CO₂ step FIG. 6 shows the intensity (a.u.) in function of the Raman shift (cm⁻¹) on the glass carrier/adhesive/MoS₂ stack of FIG. 4. This figure shows two Raman peaks, which are coming from the MoS₂ layer. The figure shows an in-plane (E_{2g}) mode located around 383 cm⁻¹ and an out-of-plane (A_{1g}) mode which is located at 407 cm⁻¹. This figure therefore demonstrates that mechanical MoS₂ peeling from sapphire is possible after a supercritical CO2 step in accordance with embodiments of the present invention.

Methods according to embodiments if the present invention may furthermore comprise transferring the film to a target substrate after peeling the substrate from the film and removing the carrier. This may for example be done as illustrated in FIG. 1 and FIG. 2 where the film 102 is bonded to the target substrate 105. After the transfer step the carrier 108 and the adhesive 106 are removed. If a laser release layer 107 is present between the adhesive 106 and the carrier 108 removal of the carrier may be achieved by a laser release step.

The target may be obtained using a CMOS process flow.

Transfer of the film on the target may be done while processing the target in the front end of line (FEOL). This may be done after a processing step of the target in the FEOL. This allows for example to obtain MX2 channel-based tunnel FETs.

Transfer of the film on the target may be done while processing the target in the back end of line (BEOL). This may be done after a processing step of the target in the BEOL. In an exemplary embodiment of the present invention graphene can for example be used as a barrier layer for Cu in the BEOL.

Before transferring the film to the target, a passivation layer may be applied to the target.

In methods according to embodiments of the present invention, after synthesis of the film on the growth substrate and after transfer of the film to a target substrate, the growth template may be recycled and re-used for synthesizing a new film.

Methods according to embodiments of the present invention may be applied for stacking more than one film by applying the method more than once.

Methods according to embodiments of the present invention may for example be applied to realize devices that require a high quality transferred 2D material. Possible applications are for example: photonic modulators, photonic detectors, gas sensors, hall sensors, DNA sensors, 2D transistors.

It is an advantage of embodiments of the present invention that a better transfer yield can be achieved. This is enabled by intercalating the supercritical fluid as it reduces the adhesion between the film and the substrate.

## Claims

1. A method (200) for delaminating a film (102) from a substrate (101), the method comprising:
- providing (210) a substrate (101) of a first material in direct contact with a film (102) of a second material,
- bonding (220) the film (102) to a carrier (108) using an adhesive (106),
- intercalating (230) a supercritical fluid between the film (102) and the substrate (101), wherein the supercritical fluid has a critical temperature below a glass transition temperature of the adhesive (106),
- mechanical peeling (240) of the substrate (101) from the film (102), after intercalating (230) the supercritical fluid.

2. A method (200) according to claim 1 wherein the first material and the second material are epitaxially matched.

3. A method (200) according to any of the previous claims, wherein the first material of the provided (210) substrate (101) is sapphire or aluminum nitride.

4. A method (200) according to any of the previous claims, wherein the second material is a metal dichalcogenide.

5. A method (200) according claim 1, wherein the first material is platinum or copper, and wherein the second material is graphene.

6. A method (200) according to claim 1, where the second material is hexagonal boron nitride.

7. A method (200) according to any of the previous claims, wherein the supercritical fluid comprises non-polar molecules.

8. A method (200) according to claim 7, wherein the supercritical fluid comprises CO2.

9. A method (200) according to any of the previous claims wherein the supercritical fluid comprises polar molecules.

10. A method (200) according to any of the previous claims, the method furthermore comprising
- transferring the film to a target after peeling the substrate from the film,
- removing the carrier.

11. A method (200) according to claim 10, wherein the target is made using a CMOS process flow.

12. A method (200) according to claim 11, wherein the film is transferred on the target after a processing step of the target in the front end of line.

13. A method (200) according to claim 11, wherein the film is transferred on the target after a processing step of the target in the back end of line.

14. A method (200) according to any of the claims 11 to 13, wherein a passivation layer is applied on the target before transferring the film.

15. A method (200) according to any of the previous claims, wherein a laser release layer (107) is provided between the adhesive (106) and the carrier (108).

## Patentansprüche

1. Ein Verfahren (200) zum Delaminieren einer Folie (102) von einem Substrat (101), wobei das Verfahren umfasst:
- Bereitstellen (210) eines Substrats (101) aus einem ersten Material in direktem Kontakt mit einer Folie (102) aus einem zweiten Material,
- Verbinden (220) der Folie (102) mit einem Träger (108) unter Verwendung eines Klebstoffs (106),
- Interkalieren (230) eines überkritischen Fluids zwischen der Folie (102) und dem Substrat (101), wobei das überkritische Fluid eine kritische Temperatur unterhalb einer Glasübergangstemperatur des Klebstoffs (106) aufweist,
- mechanisches Abziehen (240) des Substrats (101) von der Folie (102), nachdem das überkritische Fluid interkaliert (230) wurde.

2. Ein Verfahren (200) nach Anspruch 1, wobei das erste Material und das zweite Material epitaktisch aufeinander abgestimmt werden.

3. Ein Verfahren (200) nach einem der vorstehenden Ansprüche, wobei das erste Material des bereitgestellten (210) Substrats (101) Saphir oder Aluminiumnitrid ist.

4. Ein Verfahren (200) nach einem der vorstehenden Ansprüche, wobei das zweite Material ein Metalldichalcogenid ist.

5. Ein Verfahren (200) nach Anspruch 1, wobei das erste Material Platin oder Kupfer ist, und wobei das zweite Material Graphen ist.

6. Ein Verfahren (200) nach Anspruch 1, wobei das zweite Material hexagonales Bornitrid ist.

7. Ein Verfahren (200) nach einem der vorstehenden Ansprüche, wobei das überkritische Fluid nichtpolare Moleküle umfasst.

8. Ein Verfahren (200) nach Anspruch 7, wobei das überkritische Fluid CO2 umfasst.

9. Ein Verfahren (200) nach einem der vorstehenden Ansprüche, wobei das überkritische Fluid polare Moleküle umfasst.

10. Ein Verfahren (200) nach einem der vorstehenden Ansprüche, das Verfahren des Weiteren umfassend
- Übertragen der Folie auf ein Ziel, nachdem das Substrat von der Folie abgezogen wurde,
- Entfernen des Trägers.

11. Ein Verfahren (200) nach Anspruch 10, wobei das Ziel unter Verwendung eines CMOS-Prozessflusses hergestellt wird.

12. Ein Verfahren (200) nach Anspruch 11, wobei die Folie nach einem Verarbeitungsschritt des Ziels im vorderen Ende der Linie auf das Ziel übertragen wird.

13. Ein Verfahren (200) nach Anspruch 11, wobei die Folie nach einem Verarbeitungsschritt des Ziels im hinteren Ende der Linie auf das Ziel übertragen wird.

14. Ein Verfahren (200) nach einem der Ansprüche 11 bis 13, wobei vor dem Übertragen der Folie eine Passivierungsschicht auf das Ziel aufgebracht wird.

15. Ein Verfahren (200) nach einem der vorstehenden Ansprüche, wobei eine Lasertrennschicht (107) zwischen dem Klebstoff (106) und dem Träger (108) bereitgestellt wird.

## Revendications

1. Un procédé (200) pour délaminer un film (102) d'un substrat (101), le procédé comprenant :
- la fourniture (210) d'un substrat (101) d'un premier matériau en contact direct avec un film (102) d'un second matériau,
- la liaison (220) du film (102) à un support (108) à l'aide d'un adhésif (106),
- l'intercalement (230) d'un fluide supercritique entre le film (102) et le substrat (101), dans lequel le fluide supercritique présente une température critique inférieure à une température de transition vitreuse de l'adhésif (106),
- le décollement mécanique (240) du substrat (101) du film (102), après l'intercalement (230) du fluide supercritique.

2. Un procédé (200) selon la revendication 1, dans lequel le premier matériau et le second matériau sont adaptés par épitaxie.

3. Un procédé (200) selon l'une quelconque des revendications précédentes, dans lequel le premier matériau du substrat (101) fourni (210) est le saphir ou le nitrure d'aluminium.

4. Un procédé (200) selon l'une quelconque des revendications précédentes, dans lequel le second matériau est un dichalcogénure de métal.

5. Un procédé (200) selon la revendication 1, dans lequel le premier matériau est le platine ou le cuivre et dans lequel le second matériau est le graphène.

6. Un procédé (200) selon la revendication 1, dans lequel le second matériau est le nitrure de bore hexagonal.

7. Un procédé (200) selon l'une quelconque des revendications précédentes, dans lequel le fluide supercritique comprend des molécules non polaires.

8. Un procédé (200) selon la revendication 7, dans lequel le fluide supercritique comprend du CO2.

9. Un procédé (200) selon l'une quelconque des revendications précédentes, dans lequel le fluide supercritique comprend des molécules polaires.

10. Un procédé (200) selon l'une quelconque des revendications précédentes, le procédé comprenant en outre :
- le transfert du film à une cible après le décollement du substrat du film,
- le retrait du support.

11. Un procédé (200) selon la revendication 10, dans lequel la cible est réalisée à l'aide d'un flux de traitement CMOS.

12. Un procédé (200) selon la revendication 11, dans lequel le film est transféré sur la cible après une étape de traitement de la cible dans l'extrémité avant d'une ligne.

13. Un procédé (200) selon la revendication 11, dans lequel le film est transféré sur la cible après une étape de traitement de la cible dans l'extrémité arrière d'une ligne.

14. Un procédé (200) selon l'une quelconque des revendications 11 à 13, dans lequel une couche de passivation est appliquée sur la cible avant le transfert du film.

15. Un procédé (200) selon l'une quelconque des revendications précédentes, dans lequel une couche détachable par laser (107) est disposée entre l'adhésif (106) et le support (108).
